# EUROPÄISCHE PATENTSCHRIFT

(11) **EP 2 626 895 B1**
(45) Veröffentlichungstag und Bekanntmachung des Hinweises auf die Patenterteilung: **08.04.2015**
(21) Anmeldenummer: 12000793.5
(22) Anmeldetag: 07.02.2012
(51) Int. Cl.: H01L 21/67, H01L 21/304, H01L 21/78, B23K 26/40

(54) **Verfahren und Vorrichtung zum parallelen Trennen eines Werkstücks in mehere Teilstücke**
Method and device for singulating in parallel a workpiece into several segments
Méthode et dispositif pour la séparation en parallel d'une pièce en plusieurs segments

(43) Veröffentlichungstag der Anmeldung: 14.08.2013
(73) Patentinhaber: Fraunhofer-Gesellschaft zur Förderung der angewandten Forschung, 80686 München (DE)
(72) Erfinder: Lorenz, Jürgen, Dr., 91077 Neunkirchen a. Br. (DE); Koitzsch, Matthias, 91052 Erlangen (DE); Schellenberger, Martin, 91054 Erlangen (DE); Lewke, Dirk, 91056 Erlangen (DE); Gumprecht, Thomas, 09130 Chemnitz (DE)
(74) Vertreter: Gagel, Roland

(56) Entgegenhaltungen:
- US-A1- 2002 060 210
- US-A1- 2005 202 651

## Beschreibung

### Technisches Anwendungsgebiet

Die vorliegende Erfindung betrifft ein Verfahren sowie eine Vorrichtung zum parallelen Trennen eines Werkstücks in mehrere Teilstücke, bei dem mit mehreren ersten Trennwerkzeugen gleichzeitig mehrere erste Schnitte entlang erster Schnittlinien im Werkstück erzeugt werden, und mit mehreren zweiten Trennwerkzeugen gleichzeitig mehrere zweite Schnitte entlang zweiter Schnittlinien im Werkstück erzeugt werden, wobei die ersten und zweiten Schnittlinien eine Ebene aufspannen, in der sie sich schneiden oder aufeinander treffen.

In vielen technischen Bereichen ist es erforderlich, ein größeres Werkstück in mehrere in der Regel formgleiche Teilstücke aufzutrennen oder aus einem Werkstück mehrere gleichförmige Strukturen herauszutrennen. Ein Beispiel ist die Vereinzelung von Bauelementen oder Chips in der Halbleiterindustrie oder verwandten Industrien, wie bspw. MEMS, Solar oder Optik. Dort wird eine Vielzahl von Bauelementen auf einem gemeinsamen Substrat gefertigt. Sind die Bauelemente vollständig prozessiert, müssen sie voneinander getrennt werden, damit sie einzeln weiter verarbeitet werden können. Dieser Trennprozess, die Vereinzelung der Bauelemente, lässt sich mit dem vorgeschlagenen Verfahren sowie der vorgeschlagenen Vorrichtung durchführen. Das Verfahren und die Vorrichtung lassen sich in gleicher Weise selbstverständlich auch auf anderen technischen Gebieten einsetzen, bspw. in der Glas- und Keramik-Industrie, in der Verpackungsindustrie, in der Metallindustrie oder in der Holzindustrie.

### Stand der Technik

Im Folgenden wird die Problematik bei der Trennung eines Werkstücks in mehrere Teilstücke anhand der Anwendung in der Halbleiterindustrie erläutert. Für den Vereinzelungsprozess existierten dort verschiedene Verfahren und Vorrichtungen. Derzeit werden die auf Substraten gefertigten Bauelemente meist mit Hilfe von mechanischen oder laserbasierten Technologien getrennt. Daneben gibt es aus mechanischen und laserbasierten Verfahren kombinierte Technologien sowie Plasmaätzverfahren und Trennverfahren mittels Dünnschleifen. Die beiden letztgenannten Verfahren sowie die kombinierten Verfahren spielen derzeit nur eine untergeordnete Rolle.

Unabhängig von der gewählten Trenntechnologie muss vor dem Trennprozess das zu trennende Substrat auf einem Träger fixiert werden, damit das Substrat während der Bearbeitung nicht verrutscht, die Bauelemente kontrolliert getrennt werden können und bereits getrennte Bauelemente nicht abhanden kommen. Die Art der Fixierung wird abhängig von dem zu bearbeitenden Substrat gewählt. In der Mikroelektronik wird z. B. häufig eine Fixierung des Substrats mit Hilfe einer einseitig klebenden Folie und einem Trägerrahmen gewählt.

Häufig eingesetzte Trennverfahren sind das Trennschleifen und materialabtragende sowie abtragsfreie Laserverfahren. Beim Trennschleifen wird eine schnell rotierende Diamant-besetzte Trennscheibe wie eine Kreissäge verwendet, um die einzelnen Bauelemente zu separieren. Bei den materialabtragenden Laserverfahren wird mit Hilfe eines oder mehrerer gepulster Laserstrahlen solange Substratmaterial entlang des Ritzrahmens abgetragen, bis alle Bauelemente getrennt sind. Abtragsfreie Laserverfahren basieren auf der Initiierung und Führung eines Risses durch das Substrat.

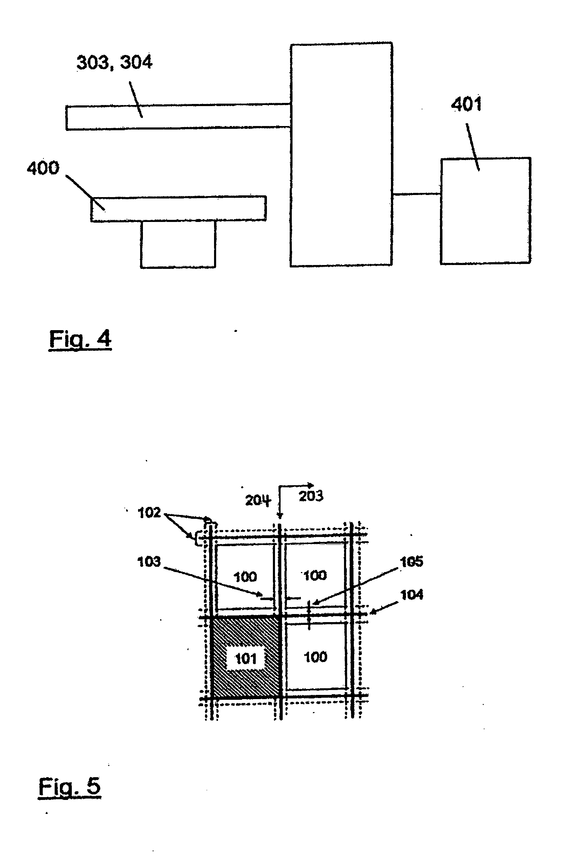

Figur 5 zeigt in Draufsicht einen Ausschnitt aus einem Substrat mit zu trennenden Chips, um die hier auftretenden Begriffe zu klären. In der Figur sind außer den Bauelementen oder Chips 100 auch die Die-Fläche 101, der Ritzrahmen 102, die Ritzrahmenbreite 103, die Trennfuge 104, die Trennfugen-Breite 105 sowie die Bewegungsrichtungen 203, 204 beim Durchführen der Trennschnitte angedeutet.

Unabhängig vom verwendeten Trennverfahren werden die Ritzrahmen bisher in der Regel der Reihe nach angefahren und nach dem beschriebenen Prinzip des jeweiligen Verfahrens die Bauelemente vereinzelt. Dieser sequentielle Ansatz, bei dem die Ritzrahmenabschnitte, auch als Straßen oder Sägestraßen bezeichnet, nacheinander bearbeitet werden, resultiert jedoch in einem geringen Durchsatz und damit hohen Kosten pro getrenntem Bauelement. Dies gilt insbesondere bei kleinen Bauelementabmessungen und gleichzeitig großen Substraten.

Aus der US 2005/0202651 A1 ist ein Verfahren zur Trennung eines Substrats in mehrere formgleiche Teilstücke bekannt, bei dem mehrere Laserstrahlen gleichzeitig so über das Substrat geführt werden, dass für jede zu bearbeitende Straße ein Strahl zur Verfügung steht. Damit wird der Durchsatz beim Vereinzeln der Bauelemente gegenüber den üblichen rein sequentiellen Trennverfahren deutlich erhöht. In einer Ausgestaltung des beschriebenen Verfahrens wird mit zwei senkrecht zueinander angeordneten Laserschienen gearbeitet, wobei mit der ersten Laserschiene die Straßen in der einen Richtung und mit der zweiten Laserschiene anschließend die Straßen in der senkrecht dazu verlaufenden zweiten Richtung bearbeitet werden. Die Laserschienen sind als Laser-Multistrahl-Einheiten ausgebildet und stellen jeweils die erforderliche Anzahl an Laserstrahlen zur Verfügung. Primäres Ziel des in der Druckschrift vorgeschlagenen Verfahrens ist die Minimierung der Ritzrahmenbreite. Hierzu wird vor der Trennung des Substrats mit Hilfe eines materialabtragenden Kurzpuls-Lasers oder mit Hilfe eines Ätzprozesses eine rückseitige breite Kerbe in das Substrat eingebracht. Bei Verwendung eines Ätzprozesses ist zur Maskierung der nicht zu bearbeitenden Oberfläche ein LithographieSchritt notwendig. Nach dem Ätz-Prozess muss die Maskierungsschicht wieder entfernt werden. Diese zusätzlichen Prozessschritte verringern allerdings den Durchsatz. Weiterhin sind bei dem Verfahren dieser Druckschrift eine Drehung des Substrates sowie eine Anpassung der Substratfixierung erforderlich, da einmal von der Substrat-Rückseite und einmal von der Substrat-Vorderseite gearbeitet wird. Auch diese zusätzlichen Prozessschritte verringern den Durchsatz. Durch die breite rückseitige Kerbe kann von der Substrat-Vorderseite mit einem schmal fokussierten materialabtragenden Laser gearbeitet werden, der eine sehr schmale Kerbe erzeugt. Dadurch entsteht eine Stufe im Profil der Bauelement-Seitenfläche, die deshalb nicht gerade verläuft. Die entstehenden Bauelement-Seitenflächen und Bauelement-Kanten sind daher nicht gerade und auch nicht glatt, was in einer verminderten Bruchfestigkeit, einem optischen Makel und eventuell auftretenden Problemen bei der an den Trennprozess anschließenden Weiterverarbeitung der Bauelemente resultiert.

Die Aufgabe der vorliegenden Erfindung besteht darin, ein Verfahren sowie eine Vorrichtung zur Trennung eines Werkstücks in mehrere Teilstücke anzugeben, die einen erhöhten Durchsatz bei hoher Kantenqualität ermöglicht.

### Darstellung der Erfindung

Die Aufgabe wird mit dem Verfahren und der Vorrichtung gemäß den Patentansprüchen 1 und 11 gelöst. Vorteilhafte Ausgestaltungen des Verfahrens sowie der Vorrichtung sind Gegenstand der abhängigen Patentansprüche oder lassen sich der nachfolgenden Beschreibung sowie den Ausführungsbeispielen entnehmen.

Bei dem vorgeschlagenen Verfahren zur Trennung eines Werkstücks in mehrere, insbesondere formgleiche, Teilstücke werden mit mehreren ersten Trennwerkzeugen durch eine Relativbewegung zwischen den erstem Trennwerkzeugen und dem Werkstück zeitlich parallel mehrere erste Schnitte entlang erster Schnittlinien und mit mehreren zweiten Trennwerkzeugen durch eine Relativbewegung zwischen den zweiten Trennwerkzeugen und dem Werkstück zeitlich parallel mehrere zweite Schnitte entlang zweiter Schnittlinien im Werkstück erzeugt. Die ersten und zweiten Schnittlinien spannen dabei eine Ebene auf, in der sie sich schneiden oder aufeinander treffen. Das vorgeschlagene Verfahren zeichnet sich dadurch aus, dass die Erzeugung zumindest eines Teils der ersten Schnitte gleichzeitig mit der Erzeugung zumindest eines Teils der zweiten Schnitte erfolgt. Die ersten Trennwerkzeuge werden daher zumindest zum Teil gleichzeitig mit den zweiten Trennwerkzeugen eingesetzt.

Mit dem Verfahren und der zugehörigen Vorrichtung wird somit eine massiv parallele Trennung der Teilstücke aus dem Werkstück erreicht, insbesondere von Bauelementen aus Substraten, Platten oder Scheiben aus unterschiedlichen Materialien, z. B. Halbleitermaterialien oder Glas. Die gleichzeitige Durchführung der Schnitte entlang der ersten und zweiten Schnittlinien erfolgt dabei vorzugsweise derart aufeinander abgestimmt, dass jedes Teilstück durch gleichzeitige Bearbeitung von mindestens einem zu den ersten und mindestens einem zu den zweiten Schnittlinien gehörenden Schnittlinienabschnitt herausgetrennt wird, die das Teilstück umgrenzen. Dadurch bildet ein noch nicht bearbeiteter Bereich des Werkstücks immer eine zusammenhängende Einheit. Es muss daher auch keine Nachjustage durchgeführt werden, wie sie bei dem Verfahren der bereits beschriebenen US 2005/0202651 A1 erforderlich sein kann. Dort müssen die nach dem ersten Trennschritt erhaltenen Streifen vor dem zweiten Trennschritt entweder so gut fixiert sein, dass sie exakt zueinander positioniert bleiben, oder neu zueinander positioniert werden. Im Gegensatz dazu existiert beim hier vorgeschlagenen Verfahren in der oben beschriebenen bevorzugten Ausgestaltung eine einfache Grenze zwischen einem in beiden Richtungen bereits bearbeiteten Bereich des Werkstücks und einem noch vollständig unbearbeiteten Bereich.

Das vorgeschlagene Verfahren und die zugehörige Vorrichtung sind hierbei sowohl für mechanische als auch für laserbasierte Trennverfahren - materialabtragende und nicht materialabtragende Verfahren - anwendbar. Unter dem Begriff des Trennwerkzeugs sind daher beim vorgeschlagenen Verfahren und der zugehörigen Vorrichtung sowohl mechanische Elemente, wie bspw. eine Trennscheibe, Abrasivstrahlen wie bspw. Wasser oder Sandstrahlen, als auch energetische Strahlen, wie bspw. Laserstrahlen, Elektronenstrahlen oder Ionenstrahlen zu verstehen. Statt mit nur einem Trennwerkzeug sequentiell zu arbeiten, werden bei dem vorgeschlagenen Verfahren mit mehreren Trennwerkzeugen, bspw. mehreren Laserstrahlen oder mehreren Trennscheiben, gleichzeitig mehrere oder alle Schnittlinien gleichzeitig bearbeitet. Die Schnittlinien stellen hierbei beispielsweise die in Zusammenhang mit Figur 5 genannten Ritzrahmenabschnitte oder Sägestraßen dar. Damit wird gegenüber dem Stand der Technik ein deutlich höherer Durchsatz bei der Trennung des Werkstücks in die einzelnen Teilstücke erreicht. Dies führt zu einer deutlichen Kostenreduzierung bei gleich bleibender Kantenqualität der getrennten Teilstücke bzw. Bauelemente. Zudem wird die Fixierung der zu vereinzelnden Teilstücke vereinfacht. Die Werkstücke werden dabei vorzugsweise nur von einer Seite bearbeitet und mit den Trennwerkzeugen in einem oder mehreren Durchgängen vollständig durchtrennt. Damit werden vorteilhaft auch gerade Seitenflächen und Kanten der Teilstücke erzeugt, die für viele Anwendungen wichtig sind.

In einer Ausgestaltung des Verfahrens erstrecken sich die ersten und zweiten Schnittlinien jeweils von einer Seite oder Kante des Werkstücks zur gegenüber liegenden Seite oder Kante. Die Schnittlinien können hierbei geradlinig verlaufen oder auch beliebige ein-oder mehrfache Krümmungen aufweisen. In einer Ausführungsform des vorgeschlagenen Verfahrens erstrecken sich die Schnittlinien dabei jeweils geradlinig von einer Seite bzw. Kante des Werkstücks zur gegenüber liegenden Seite oder Kante, wobei die ersten Schnittlinien vorzugsweise senkrecht zu den zweiten Schnittlinien verlaufen. Damit werden im Querschnitt rechteckige oder quadratische Teilstücke aus dem Werkstück herausgetrennt. Bei einem nicht senkrechten Verlauf der Schnittlinien ergeben sich entsprechend im Querschnitt rautenförmige Teilstücke.

Vorzugsweise werden gerade so viele Trennwerkzeuge eingesetzt, wie Schnittlinien bzw. Sägestraßen in der jeweiligen Richtung vorhanden sind. Bei Nutzung von Laserstrahlen als Trennwerkzeugen kann jeweils auch lediglich ein einziger Laser eingesetzt werden, dessen Laserstrahl auf mehrere Teilstrahlen aufgespaltet wird, die die Trennwerkzeuge im Sinne des hier vorgeschlagenen Verfahrens bzw. der zugehörigen Vorrichtung darstellen. Selbstverständlich ist auch der Einsatz mehrerer Laser zur Erzeugung der Bearbeitungs-Laserstrahlen möglich. Grundsätzlich kann das vorgeschlagene Verfahren auch mehrere Trennverfahren kombinieren, z.B. laserbasierte und mechanische Trennverfahren, um das Werkstück in die unterschiedlichen Teilstücke zu trennen.

In einer vorteilhaften Ausgestaltung des vorgeschlagenen Verfahrens und der zugehörigen Vorrichtung sind die ersten Trennwerkzeuge entlang einer ersten Achse und die zweiten Trennwerkzeuge entlang einer zweiten Achse angeordnet oder aufgereiht, wobei die beiden Achsen während der Erzeugung der Schnitte parallel zueinander ausgerichtet sind. Durch geeignete Verschiebung der beiden Achsen parallel zueinander werden gleichzeitig Schnitte in zwei Richtungen erzeugt, die eine Ebene aufspannen. Ggfs. ist dies auch mit drei Achsen in drei Richtungen möglich. Vorzugsweise sind diese beiden Achsen durch Trägerelemente gebildet, bspw. durch Führungsschienen, an denen die Trennwerkzeuge oder Komponenten zur Führung der Trennwerkzeuge befestigt sind. Die beiden Trägerelemente können hierbei vorteilhafter Weise aneinander grenzen und sind entlang der ersten oder zweiten Achse relativ zueinander beweglich, um die Trennwerkzeuge während der Relativbewegung zum Werkstück entlang der Schnittlinien zu führen. Die Relativbewegung zwischen den Trennwerkzeugen und dem Werkstück kann dabei durch Bewegung des Werkstücks, durch Bewegung der Trennwerkzeuge und/oder Trägerelemente oder auch durch Bewegung sowohl des Werkstücks als auch der Trennwerkzeuge und/oder Trägerelemente erreicht werden. Im Falle der Nutzung von Laserstrahlen als Trennwerkzeuge weisen die Trägerelemente vorzugsweise optische Umlenkelemente auf, mit denen die Laserstrahlen auf das Werkstück gerichtet werden. Anstelle einfacher Strahlumlenkelemente können auch optische Scaneinrichtungen an den Trägerelementen befestigt sein, so dass die Führung entlang der Schnittlinien auch zumindest zum Teil über diese Scaneinrichtungen gesteuert werden kann.

In einer weiteren vorteilhaften Ausgestaltung sind mehrere der ersten und zweiten Trennwerkzeuge jeweils in Schnittrichtung hintereinander angeordnet. Auf diese Weise kann bspw. auch ein dickeres Werkstück durchtrennt werden, für das ansonsten mehrere Schneiddurchgänge erforderlich wären.

Beim Einsatz von Laserstrahlen oder anderen energetischen Strahlen als Trennwerkzeuge können diese über geeignete Scaneinrichtungen entlang der ersten und zweiten Schnittlinien geführt werden. Dies ermöglicht bei einer ausreichend großen Anzahl an derartigen Bearbeitungsstrahlen und zugehörigen Scaneinrichtungen auch eine gleichzeitige Bearbeitung aller oder zumindest einiger Teilstücke zur Trennung vom Werkstück.

Die vorgeschlagene Vorrichtung zur Durchführung des Verfahrens umfasst entsprechend eine Halterung für das Werkstück und ein oder mehrere Trägerelemente für die mehreren ersten und zweiten Trennwerkzeuge. Die vorgeschlagene Vorrichtung zeichnet sich dadurch aus, dass sie eine Steuereinrichtung aufweist, die die Trennwerkzeuge zur Durchführung der Schnitte so ansteuert, dass sie zumindest einen Teil der Schnitte gemäß dem vorgeschlagenen Verfahren gleichzeitig entlang der ersten und zweiten Schnittlinien erzeugen.

Die mit dem vorgeschlagenen Verfahren und der zugehörigen Vorrichtung abgetrennten Teilstücke können nahezu beliebige Querschnittsformen aufweisen, bspw. Rechtecke, Rechtecke mit abgerundeten Ecken, Vielecke oder kreisförmige Strukturen sein. Das Verfahren lässt sich nicht nur mit platten- oder scheibenförmigen Werkstücken durchführen, sondern auch auf drei Dimensionen erweitern, indem statt zwei Arten von Schnittlinien drei Arten von Schnittebenen ausgeführt werden, die das Gesamtvolumen aufspannen und dazu mit drei Sätzen von Trennwerkzeugen bearbeitet werden. Damit lassen sich dreidimensionale Strukturen, wie bspw. Würfel oder Quader aus einem massiven Werkstück heraustrennen.

Das Verfahren und die Vorrichtung lassen sich auf den unterschiedlichsten technischen Gebieten einsetzen. So können im Bereich der Mikroelektronik oder Nanoelektronik Halbleiterscheiben unterschiedlicher Zusammensetzungen hinsichtlich des Substratmaterials und zu trennender Schichtstapel parallel getrennt werden. Hier kommen alle Substrate in Frage, die auch mit den bekannten Verfahren des Standes der Technik bearbeitet werden können. Dies sind z. B. mono- und multikristalline Halbleiter, Verbindungshalbleiter, amorphe Halbleiter für den Einsatz in der Photovoltaik u.a. Auch Systeme mit kombinierten elektrischen, mechanischen, chemischen und/oder biologischen Bestandteilen, z. B. mikro-elektromechanische Systeme (MEMS) oder nano-elektromechanische Systeme (NEMS), lassen sich gemäß dem vorgeschlagenen Verfahren bearbeiten. In der Glas- und Keramikindustrie kann das Verfahren bspw. bei der Herstellung von Displays, Fliesen usw. eingesetzt werden. Das Verfahren lässt sich auch in der Verpackungsindustrie einsetzen, um z. B. aus einem Endlos-Band bestimmte Bereiche zu perforieren oder herauszutrennen. In der Metallindustrie ermöglicht das Verfahren das parallele laser-basierte Trennen von Blechen oder Blöcken unterschiedlicher Metalle in gleichförmige Strukturen oder Quader. Bei einer Anwendung in der Holzindustrie lassen sich parallel laufende mechanische Sägen zum Trennen von Holzplatten oder Holzblöcken in gleichförmige Strukturen, z. B. Rechtecke oder Quader, einsetzen. Das Verfahren und die Vorrichtung sind selbstverständlich nicht auf die obigen beispielhaft angeführten Anwendungen beschränkt.

### Kurze Beschreibung der Zeichnungen

Das Verfahren und die zughörige Vorrichtung werden nachfolgend anhand von Ausführungsbeispielen in Verbindung mit den Zeichnungen nochmals näher erläutert. Hierbei zeigen:
- Figur 1: eine schematische Darstellung einer beispielhaften Arbeitsreihenfolge bei der Nutzung des vorgeschlagenen Verfahrens zum Trennen eines Substrats;
- Figur 2: einen beispielhaften Aufbau zur Durchführung des vorgeschlagenen Verfahrens zum Trennen eines Substrats;
- Figur 3: einen weiteren beispielhaften Aufbau zur Durchführung des vorgeschlagenen Verfahrens zum Trennen eines Substrats; und
- Figur 4: eine stark schematisierte Darstellung einer Vorrichtung zur Durchführung des Verfahrens; und
- Figur 5: eine schematische Darstellung eines Abschnittes eines Substrates mit Bauelementen in Draufsicht.

### Wege zur Ausführung der Erfindung

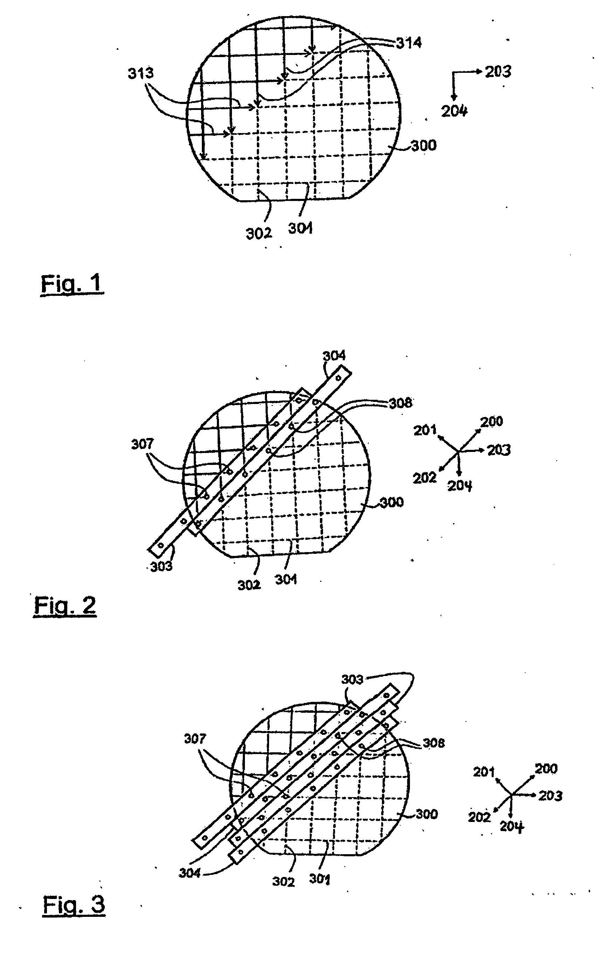

Die schematische Darstellung eines Ausschnitts aus einem Substrat mit Bauelementen bzw. Chips in Figur 5 wurde bereits in der Beschreibungseinleitung erläutert. Im Folgenden wird die Durchführung des Verfahrens bei der Trennung eines Halbleitersubstrats 300 in einzelne Chips nochmals näher erläutert. Hierbei zeigt Figur 1 in schematischer Darstellung eine beispielhafte Arbeitsreihenfolge beim Einsatz des vorgeschlagenen Verfahrens bzw. der vorgeschlagenen Vorrichtung. Für die Trennung werden mehrere Trennwerkzeuge verwendet, vorzugsweise so viele Trennwerkzeuge, z. B. Laserstrahlen oder Trennscheiben, wie es Sägestraßen 301, 302 in X-Richtung 203 und Y-Richtung 204 gibt. Dies kann auch durch Aufspaltung eines Ausgangslaserstrahls eines einzelnen Lasers erfolgen oder auch durch die Nutzung mehrerer Laser oder mechanischer Trennwerkzeuge wie bspw. Trennscheiben. Der Trennvorgang in X- und Y-Richtung 203, 204 wird gleichzeitig in beiden Richtungen durchgeführt, wie dies mit den durchgezogenen Pfeilen in der Figur 1 veranschaulicht ist. Die gestrichelten Linien stellen dabei die noch nicht bearbeiteten ersten und zweiten Schnittlinien bzw. Sägestraßen 301, 302 dar.

Aus der Figur 1 ist ersichtlich, dass jeder Chip durch gleichzeitige Bearbeitung (gleichzeitiges Schneiden) von einem zu den ersten Sägestraßen 301 gehörenden Sägestraßenabschnitt und einem zu den zweiten Sägestraßen 302 gehörenden Sägestraßenabschnitt herausgetrennt wird, die den Chip umgrenzen. Dies erfolgt bei dem Beispiel der Figur 1 durch eine Anordnung der ersten und zweiten Trennwerkzeuge auf zueinander parallelen und eng beieinander liegenden Achsen, die schräg zur ersten und zweiten Schnittrichtung 203, 204 orientiert sind. Dadurch entsteht eine klare dem Verlauf der Achsen entsprechende Grenze auf dem Substrat 300 zwischen bereits abgetrennten und noch abzutrennenden Chips. Damit bildet der noch zu trennende Bereich des Substrats 300 stets eine Einheit, die keine gesonderte Fixierung oder Nachjustage von Einzelteilen für den Schneidvorgang erfordert. Eine Relativbewegung der ersten und zweiten Schneidwerkzeuge zum Substrat um die einen Chip entsprechende Distanz führt immer zur Abtrennung eines oder mehrerer Chips.

Eine derartige Bearbeitung kann in unterschiedlicher Weise realisiert werden. Die Figuren 2 und 3 zeigen Möglichkeiten zur Umsetzung. Die in diesen Figuren schematisch angedeuteten Trennwerkzeuge 307, 308 können beispielsweise geeignet angeordnete laser-basierte und/oder mechanische Trennwerkzeuge sein.

In dem Beispiel der Figur 2 werden die beiden Gruppen von Trennwerkzeugen 307, 308 für die X-Richtung 203 und die Y-Richtung 204 jeweils über ein als Träger-oder Führungsschiene für die X- und für die Y-Richtung ausgebildetes Trägerelement 303, 304 geführt. Es können auch für eine Richtung oder für beide Richtungen mehrere Trägerelemente 303, 304 verwendet werden, wie dies in der Figur 3 beispielhaft dargestellt sind. Hierzu sind entsprechend mehrere Trennwerkzeuge 307, 308 bzw. im Falle von Laserstrahlung entsprechende Strahl-Umlenkelemente oder Strahl-Aufspaltungselemente für die Aufspaltung eines Laserstrahls in mehrere Teilstrahlen erforderlich.

Die Trägerelemente 303, 304 für die X- und Y-Richtung 203, 204 können in den durch Pfeile in den Figuren 2 und 3 angedeuteten Bewegungsrichtungen 200, 202 gegeneinander bewegt werden. Hierdurch wird sichergestellt, dass für die Bearbeitung das Trägerelement 303 in der X-Richtung 203 und das Trägerelement 304 in der Y-Richtung 204 über das Substrat 300 bewegt werden können, während beide Trägerelemente dabei zueinander parallel bleiben. Der Abstand beider Trägerelemente sollte möglichst geringer als die Diagonale der zu vereinzelnden Bauelemente bzw. Chips sein. Das Substrat 300 wird unterhalb der Trägerelemente 303, 304 auf einem Substrathalter fixiert. Der Substrathalter ist ebenfalls in der X-Y-Ebene beweglich.

Bei geeigneter relativer Bewegung der Trägerelemente 303, 304 für die X- und Y-Richtung 203, 204 sowie des Substrathalters können z. B. rechteckförmige Bauelemente oder Chips aus dem Substrat 300 herausgetrennt werden, wie dies schematisch in den Figuren 2 und 3 angedeutet ist. Dies kann bspw. in folgender Weise erfolgen:
- Werden die Trägerelemente 303, 304 in Bewegungsrichtung 200 bzw. 202 gegeneinander bewegt, wie dies in den Figuren 2 und 3 angedeutet ist, und das Substrat 300 unterhalb der Trägerelemente 303, 304 senkrecht zur Längsachse der Trägerelemente in Richtung 201 verfahren, so erfolgt die Trennung der einzelnen Chips in diesem Beispiel diagonal von oben links nach unten rechts.
- Werden die Trägerelemente 303, 304 in X- und Y-Richtung 203, 204 bewegt und das Substrat 300 unterhalb der Trägerelemente ruht, so erfolgt ebenfalls die Trennung der einzelnen Chips diagonal von oben links nach unten rechts.

Die durchgezogenen Linien in den beiden Figuren deuten dabei einen bereits erfolgten Schnitt, die gestrichelten Linien noch zu bearbeitende Schnittlinien bzw. Sägestraßen oder Ritzrahmenabschnitte an. Jede der beiden langgestreckten Trägerelemente 303, 304 ist dabei für die Durchführung der Schnitte in einer Richtung 203, 204 vorgesehen.

Für die Durchführung des vorgeschlagenen Verfahrens können auch mehrere Gruppen von ersten und zweiten Trennwerkzeugen 308, 307 hintereinander in Schnittrichtung eingesetzt werden, wie dies in der Figur 3 angedeutet ist. Dabei ist in diesem Beispiel zusätzlich jeweils ein zweites langgestrecktes Trägerelement 303, 304 mit entsprechenden Trennwerkzeugen 308, 307 vorgesehen. Damit können tiefere Schnitte in Werkstücken erzeugt werden, die dicker ausgebildet sind und somit bei nur einem Trennwerkzeug in Schnittrichtung mehrere Schneiddurchgänge erfordern würden.

In einer weiteren Variante des vorgeschlagenen Verfahrens sowie der zugehörigen Vorrichtung werden als Trennwerkzeuge energetische Strahlen in Verbindung mit Scaneinrichtungen eingesetzt, mit denen die energetischen Strahlen entlang der Schnittlinien geführt werden. Im Fall von Laserstrahlen können diese Scaneinrichtungen durch bewegliche Spiegelanordnungen, ein Spiegelarray mit beweglichen Mikrospiegeln, einen Aufbau mit beweglichen Linsen oder anderen optische Elementen, bspw. diffraktive optische Elemente, gebildet sein, um einen einzelnen Laserstrahl in mehrere Teilstrahlen als Trennwerkzeuge und zur Führung dieser Teilstrahlen bzw. Trennwerkzeuge in beiden Richtungen zur Bearbeitung der Schnittlinien, bspw. gemäß der in Figur 1 dargestellten Bearbeitungsreihenfolge, zu erreichen. Hierbei kann dann auch auf ein bewegliches Trägerelement verzichtet werden, da die Führung der Laserstrahlen entlang der Schnittlinien über die entsprechenden Scaneinrichtungen erfolgen kann. Es lässt sich aber auch eine Anordnung wie die der Figur 2 oder 3 mit den beweglichen Trägerelementen mit derartigen Scaneinrichtungen kombinieren, wobei dann lediglich ein Teil der Bewegung entlang der Schnittlinien über die Scaneinrichtungen durchgeführt wird.

Figur 4 zeigt schließlich stark schematisiert ein Beispiel für einen Aufbau der vorgeschlagenen Vorrichtung. Die Vorrichtung weist einen geeigneten Substrathalter 400 sowie die beiden Trägerelemente 303, 304 mit den Trennwerkzeugen 307, 308 auf. Sowohl der Substrathalter 400 als auch die Trägerelemente 303, 304 sind hierbei entsprechend der Beschreibung der Figuren 2 und 3 in den dort angegebenen Richtungen verfahrbar. Eine Steuerung 401 steuert sowohl die Trennwerkzeuge 307, 308 zur Durchführung der Schnitte als auch den Antrieb für die Substrathalterung 400 und die Trägerelemente 303, 304, um die gleichzeitige Bearbeitung entlang der gewünschten Schnittlinien zu erreichen.

Mit dem vorgeschlagenen Verfahren wird der Durchsatz bei gleich bleibender Qualität des Trennergebnisses signifikant erhöht. Dies kann anhand der folgenden Abschätzung gegenüber einer sequentiellen Bearbeitung verdeutlicht werden. Hierbei werden die folgenden Annahmen gemacht:
- Substratdicke = 100µm. Dies bedeutet für ein materialabtragendes laserbasiertes Verfahren, dass ein Durchgang (Pass) für eine vollständige Trennung des Substrats in einer Straße erforderlich ist.
- Durchmesser des Substrats = 300mm.
- Vorschubgeschwindigkeit = 300mm/s. Jeder Ritzrahmenabschnitt (Sägestraße) wird mit derselben Vorschubgeschwindigkeit von 300mm/s bearbeitet.
- Anzahl der zu trennenden Bauelemente pro Richtung = 100.
- Anzahl der Ritzrahmenabschnitte (Sägestraßen) pro Richtung = 101.

Die Abschätzung der Bearbeitungszeit für ein Substrat ergibt:
- Gemäß Stand der Technik: 101*300mm/ (300mm/s) *2 ≈ 200s. Zustellzeiten zwischen den einzelnen Sägestraßen werden vernachlässigt, kürzere Sägestraßen werden auf 300 mm für die Rechnung vergrößert. Diese Vereinfachung hebt sich mit der vernachlässigten Zustellzeit etwa auf.
- Trennverfahren gemäß dem hier vorgeschlagenen Verfahren: 300mm/ (300mm/s) ≈ 1s.

Damit ergibt sich eine Verbesserung gegenüber dem Stand der Technik um den Faktor 200. Ist das Substrat so dick, dass mehr als ein Durchlauf notwendig ist, um das Substrat vollständig zu trennen, kann eine weitere Parallelisierung erreicht werden, indem man für die X-und die Y-Richtung jeweils mehr als ein Trägerelement nutzt, wie dies in Verbindung mit Figur 3 bereits beispielhaft erläutert wurde. Dafür könnte eine Konstruktion herangezogen werden, die wie ein doppelter Schienenkamm ausgebildet ist, der sich ineinander verschiebt und wieder löst.

Gegenüber dem Stand der Technik ergibt sich mit dem vorgeschlagenen Verfahren ein signifikant verbesserter Durchsatz. Bei kleinen Bauelementen kommt dieser Vorteil besonders zum Tragen, da die Bearbeitungszeit durch den massiv parallelen Ansatz unabhängig von der Anzahl und der Bauelementabmessungen auf einem Substrat ist. Die Anzahl der verfügbaren Trennwerkzeuge in beiden zu bearbeitenden Richtungen sollte hierbei der Anzahl der zu bearbeitenden Ritzrahmenabschnitte bzw. Sägestraßen in beiden Richtungen entsprechen. Ist die Anzahl der zu bearbeitenden Sägestraßen zu hoch, kann auch teilweise sequentiell gearbeitet werden. Beispielsweise kann zunächst eine Hälfte des Substrats bearbeitet werden und anschließend die zweite Hälfte. Der Abstand zwischen zwei benachbarten Trennwerkzeugen sollte dem Abstand zwischen zwei benachbarten Sägestraßen entsprechen. Ist der Abstand zwischen zwei benachbarten Sägestraßen zu klein, kann ebenfalls teilweise sequentiell gearbeitet werden. Beispielsweise könnte der Abstand zwischen zwei benachbarten Trennwerkzeugen ein Vielfaches des Abstands zwischen zwei benachbarten Sägestraßen betragen. Dabei müsste mit den Trennwerkzeugen dann entsprechend öfter über das Substrat gefahren werden, um alle Bauelemente zu separieren. Der folgende Vorteil würde dabei jedoch entfallen.

Dieser Vorteil des vorgeschlagenen Verfahrens bei vollständig paralleler Bearbeitung besteht darin, dass die noch zu trennenden Bauelemente alle einem gemeinsamen verbundenen Substrat angehören, so dass der Justageaufwand bzw. die nötige Stärke der Fixierung (Kleber, Anpressdruck usw.) vermindert werden. Dies kann - je nach Anwendung - auch die Eigenschaften der letztendlich getrennten Bauelemente beeinflussen und damit die Ausbeute des Verfahrens erhöhen. Entsprechendes gilt bei geeigneter Ablauforganisation, wenn zunächst nur ein Teilbereich bearbeitet wird - dieser jedoch massiv parallel gleichzeitig in beiden Richtungen gemäß dem vorgeschlagenen Verfahren.

Mit dem Verfahren und der zugehörigen Vorrichtung lassen sich vorteilhaft vor allem kleinere Bauelemente, welche auf großen Substraten und in sehr großen Stückzahlen gefertigt werden, von den Substraten trennen. Das Verfahren und die Vorrichtung sind sowohl für mechanische als auch für laserbasierte Trennverfahren, insbesondere für die bekannten Trennverfahren des Standes der Technik, auch in Kombination, anwendbar.

Obwohl die Erfindung im Detail durch die Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen. Der Begriff des Schneidens bzw. des Schnittes steht in der vorliegenden Patentanmeldung für jedwede Art des Trennens.

### Bezugszeichenliste

- 100: Chip
- 101: Die
- 102: Ritzrahmen
- 103: Ritzrahmenbreite
- 104: Trennfuge
- 105: Trennfugen-Breite
- 200: Mögliche Bewegungsrichtung der Trennwerkzeuge für die Sägestraßen in X- und Y-Richtung
- 201: Mögliche Bewegungsrichtung des Substrathalters
- 202: Mögliche Bewegungsrichtung der Trennwerkzeuge für die Sägestraßen in X- und Y-Richtung
- 203: X-Richtung, mögliche Bewegungsrichtung der Trennwerkzeuge für die Sägestraßen in X-Richtung
- 204: Y-Richtung, mögliche Bewegungsrichtung der Trennwerkzeuge für die Sägestraßen in Y-Richtung
- 300: Substrat
- 301: Sägestraße in X-Richtung (203)
- 302: Sägestraße in Y-Richtung (204)
- 303: Trägerelement zur Führung des gewählten Trennwerkzeugs und Bearbeitung der Sägestraßen in Y-Richtung (204)
- 304: Trägerelement zur Führung des gewählten Trennwerkzeugs und Bearbeitung der Sägestraßen in X-Richtung (203)
- 307: Trennwerkzeuge für die Bearbeitung der Sägestraßen in Y-Richtung (204)
- 308: Trennwerkzeuge für die Bearbeitung der Sägestraßen in X-Richtung (203)
- 313: Schematische Darstellung der Bearbeitung der Sägestraßen in X-Richtung (203)
- 314: Schematische Darstellung der Bearbeitung der Sägestraßen in Y-Richtung (204)
- 400: Substrathalterung
- 401: Steuerung

## Patentansprüche

1. Verfahren zur Trennung eines Werkstücks in mehrere Teilstücke, bei dem
- mit mehreren ersten Trennwerkzeugen (308) gleichzeitig mehrere erste Schnitte entlang erster Schnittlinien (301) im Werkstück (300) erzeugt werden, und
- mit mehreren zweiten Trennwerkzeugen (307) gleichzeitig mehrere zweite Schnitte entlang zweiter Schnittlinien (302) im Werkstück erzeugt werden,
- wobei die ersten und zweiten Schnittlinien (301, 302) eine Ebene aufspannen, in der sie sich schneiden oder aufeinander treffen,
**dadurch gekennzeichnet**,
**dass** die Erzeugung zumindest eines Teils der ersten Schnitte gleichzeitig mit der Erzeugung zumindest eines Teils der zweiten Schnitte erfolgt.

2. Verfahren nach Anspruch 1,
**dadurch gekennzeichnet**,
**dass** die Erzeugung der Schnitte entlang der ersten und zweiten Schnittlinien (301, 302) derart aufeinander abgestimmt erfolgt, dass jedes Teilstück durch gleichzeitige Bearbeitung von mindestens einem zu den ersten (301) und mindestens einem zu den zweiten Schnittlinien (302) gehörenden Schnittlinienabschnitt herausgetrennt wird, die das Teilstück umgrenzen.

3. Verfahren nach Anspruch 1 oder 2,
**dadurch gekennzeichnet**,
**dass** die ersten Trennwerkzeuge (308) entlang einer ersten Achse und die zweiten Trennwerkzeuge (307) entlang einer zweiten Achse angeordnet sind, wobei die beiden Achsen während der Erzeugung der Schnitte parallel zueinander ausgerichtet sind.

4. Verfahren nach Anspruch 3,
**dadurch gekennzeichnet**,
**dass** die beiden Achsen durch Trägerelemente (303, 304) gebildet sind, an denen die Trennwerkzeuge (307, 308) oder Komponenten zur Führung der Trennwerkzeuge (307, 308) befestigt sind.

5. Verfahren nach Anspruch 4,
**dadurch gekennzeichnet**,
**dass** die Trägerelemente (303, 304) bei der Erzeugung der Schnitte relativ zueinander entlang der ersten oder zweiten Achse bewegt werden, um die Trennwerkzeuge (307, 308) entlang der Schnittlinien (301, 302) zu führen.

6. Verfahren nach einem der Ansprüche 1 bis 5,
**dadurch gekennzeichnet**,
**dass** die ersten und/oder zweiten Trennwerkzeuge (307, 308) mechanische Trennwerkzeuge, Fluidstrahlen oder energetische Strahlen sind.

7. Verfahren nach Anspruch 4 oder 5,
**dadurch gekennzeichnet**,
**dass** die ersten und/oder zweiten Trennwerkzeuge (307, 308) Laserstrahlen sind, die über an den Trägerelementen (303, 304) befestigte Strahlteilungs- oder Strahlumlenkelemente auf das Werkstück gerichtet werden.

8. Verfahren nach Anspruch 4 oder 5,
**dadurch gekennzeichnet**,
**dass** die ersten und/oder zweiten Trennwerkzeuge (307, 308) Laserstrahlen sind, die über an den Trägerelementen (303, 304) befestigte optische Scan-Einrichtungen zumindest teilweise entlang der Schnittlinien (301, 302) geführt werden.

9. Verfahren nach Anspruch 1 oder 2,
**dadurch gekennzeichnet**,
**dass** die ersten und zweiten Trennwerkzeuge (308, 307) energetische Strahlen sind, die über Scan-Einrichtungen entlang der ersten und zweiten Schnittlinien (301, 302) geführt werden.

10. Verfahren nach einem der Ansprüche 1 bis 9,
**dadurch gekennzeichnet**,
**dass** mehrere Gruppen von ersten und zweiten Trennwerkzeugen (307, 308) in Schnittrichtung hintereinander eingesetzt werden.

11. Vorrichtung zur Trennung eines Werkstücks in mehrere Teilstücke, die zumindest aufweist:
- mehrere erste Trennwerkzeuge (308), die zur gleichzeitigen Erzeugung mehrerer erster Schnitte entlang erster Schnittlinien (301) in einem Werkstück (300) angeordnet und ausgebildet sind
- mehrere zweite Trennwerkzeuge (307), die zur gleichzeitigen Erzeugung mehrerer zweiter Schnitte entlang zweiter Schnittlinien (302) im Werkstück (300) angeordnet und ausgebildet sind, wobei die ersten und zweiten Schnittlinien eine Ebene aufspannen, in der sie sich schneiden oder aufeinander treffen,
- eine Werkstückhalterung (400) und
**dadurch gekennzeichnet, dass** die Vorrichtung eine Steuerung (401) aufweist, die die Trennwerkzeuge (307, 308) zur Erzeugung zumindest eines Teils der ersten Schnitte gleichzeitig mit der Erzeugung zumindest eines Teils der zweiten Schnitte ansteuert.

12. Vorrichtung nach Anspruch 11,
**dadurch gekennzeichnet**,
**dass** die ersten Trennwerkzeuge (308) entlang einer ersten Achse und die zweiten Trennwerkzeuge (307) entlang einer zweiten Achse angeordnet sind, wobei die beiden Achsen während der Erzeugung der Schnitte parallel zueinander ausgerichtet sind.

13. Vorrichtung nach Anspruch 12,
**dadurch gekennzeichnet**,
**dass** die beiden Achsen durch Trägerelemente (303, 304) gebildet sind, an denen die Trennwerkzeuge (307, 308) oder Komponenten zur Führung der Trennwerkzeuge (307, 308) befestigt sind.

14. Vorrichtung nach Anspruch 13,
**dadurch gekennzeichnet**,
**dass** die Trägerelemente (303, 304) relativ zueinander entlang der ersten oder zweiten Achse verschiebbar gelagert sind.

15. Vorrichtung nach einem der Ansprüche 11 bis 14,
**dadurch gekennzeichnet**,
**dass** die ersten und/oder zweiten Trennwerkzeuge (307, 308) mechanische Trennwerkzeuge oder energetische Strahlen sind.

16. Vorrichtung nach einem der Ansprüche 11 bis 15,
**dadurch gekennzeichnet**,
**dass** die ersten und/oder zweiten Trennwerkzeuge (307, 308) Laserstrahlen eines oder mehrerer Laser sind, die über optische Scan-Einrichtungen zumindest teilweise entlang der Schnittlinien (301, 302) geführt werden können.

## Claims

1. A method for separating a work piece into several parts, in which
- several first separating tools (308) are used to simultaneously generate several first cuts along first cutting lines (301) in the work piece (300), and
- several second separating tools (307) are used to simultaneously generate several second cuts along second cutting lines (302) in the work piece,
- wherein the first and second cutting lines (301, 302) span a plane in which they intersect or hit each other,
**characterized in that**
at least a portion of the first cuts is generated simultaneously with the generation of at least a portion of the second cuts.

2. The method according to claim 1,
**characterized in that**
the generation of cuts along the first and second cutting lines (301, 302) takes place in a synchronized manner in such a way that each part is separated out by simultaneously machining at least one cutting line segment belonging to the first (301) and at least one belonging to the second (302) cutting lines, which bound the part.

3. The method according to claim 1 or 2,
**characterized in that**
the first separating tools (308) are arranged along a first axis and the second separating tools (307) along a second axis, wherein the two axes are aligned parallel to each other while generating the cuts.

4. The method according to claim 3,
**characterized in that**
the two axes are formed by carrier elements (303, 304), to which are attached the separating tools (307, 308) or components for guiding the separating tools (307, 308).

5. The method according to claim 4,
**characterized in that**
the carrier elements (303, 304) are moved relative to each other along the first or second axis while generating the cuts in order to guide the separating tools (307, 308) along the cutting lines (301, 302).

6. The method according to one of claims 1 to 5,
**characterized in that**
the first and/or second separating tools (307, 308) are mechanical separating tools, fluid jets or energy beams.

7. The method according to claim 4 or 5,
**characterized in that**
the first and/or second separating tools (307, 308) are laser beams, which are aimed at the work piece via beam splitting or beam diverting elements attached to the carrier elements (303, 304).

8. The method according to claim 4 or 5,
**characterized in that**
the first and/or second separating tools (307, 308) are laser beams, which are guided at least partially along the cutting lines (301, 302) via optical scanners attached to the carrier elements (303, 304).

9. The method according to claim 1 or 2,
**characterized in that**
the first and second separating tools (308, 307) are energy beams, which are guided along the first and second cutting lines (301, 302) via scanners.

10. The method according to one of claims 1 to 9,
**characterized in that**
several groups of first and second separating tools (307, 308) are placed one behind the other in the cutting direction.

11. A device for separating a work piece into several parts, which exhibits at least:
- several first separating tools (308) arranged and designed to simultaneously generate several first cuts along first cutting lines (301) in a work piece (300),
- several second cutting tools (307) arranged and designed to simultaneously generate several second cuts along second cutting lines (302) in the work piece (300), wherein the first and second cutting lines span a plane in which they intersect or hit each other,
- a work piece mount (400), and is **characterized in that** that the device exhibits a controller (401) that actuates the separating tools (307, 308) for generating at least one portion of the first cuts while simultaneously generating at least one portion of the second cuts.

12. The device according to claim 11,
**characterized in that**
the first separating tools (308) are arranged along a first axis and the second separating tools (307) along a second axis, wherein the two axes are aligned parallel to each other while generating the cuts.

13. The device according to claim 12,
**characterized in that**
the two axes are formed by carrier elements (303, 304), to which are attached the separating tools (307, 308) or components for guiding the separating tools (307, 308).

14. The device according to claim 13,
**characterized in that**
the carrier elements (303, 304) are mounted so that they can shift relative to each other along the first or second axis.

15. The device according to one of claims 11 to 14,
**characterized in that**
the first and/or second separating tools (307, 308) are mechanical separating tools or energy beams.

16. The device according to one of claims 11 to 15,
**characterized in that**
the first and/or second separating tools (307, 308) are laser beams from one or several lasers, which can be guided at least partially along the cutting lines (301, 302) via optical scanners.

## Revendications

1. Procédé pour séparer une pièce d'oeuvre en plusieurs pièces partielles, dans lequel
- avec plusieurs premiers outils de séparation (308), plusieurs premières entailles sont réalisées simultanément dans la pièce d'oeuvre (300) le long de premières lignes de coupe (301), et
- avec plusieurs deuxièmes outils de séparation (307), plusieurs deuxièmes entailles étant réalisées simultanément dans la pièce d'oeuvre le long de deuxièmes lignes de coupe (302),
- les premières et deuxièmes lignes de coupe (301, 302) déterminant un plan dans lequel elles se coupent ou se rencontrent,
**caractérisé en ce que** la réalisation d'au moins une partie des premières entailles s'effectue simultanément avec la réalisation d'au moins une partie des deuxièmes entailles.

2. Procédé selon la revendication 1, **caractérisé en ce que** la réalisation des entailles le long des premières et deuxièmes lignes de coupe (301, 302) s'effectue de manière harmonisée entre elles de manière à ce que chaque pièce partielle soit séparée par usinage simultané d'au moins un segment de ligne de coupe appartenant aux premières lignes de coupe (301) et au moins un segment de ligne de coupe appartenant aux deuxièmes lignes de coupe (302), lesquels délimitent la pièce partielle.

3. Procédé selon la revendication 1 ou 2, **caractérisé en ce que** les premiers outils de séparation (308) sont disposés le long d'un premier axe et les deuxièmes outils de séparation (307) le long d'un deuxième axe, les deux axes étant orientés parallèlement l'un par rapport à l'autre pendant la réalisation des entailles.

4. Procédé selon la revendication 3, **caractérisé en ce que** les deux axes sont formés par des éléments de support (303, 304) sur lesquels sont fixés les outils de séparation (307, 308) ou des composants pour le guidage des outils de séparation (307, 308).

5. Procédé selon la revendication 4, **caractérisé en ce que** les éléments de support (303, 304) sont déplacés l'un par rapport à l'autre le long du premier ou deuxième axe lors de la réalisation des entailles afin de guider les outils de séparation (307, 308) le long des lignes de coupe (301, 302).

6. Procédé selon l'une des revendications 1 à 5, **caractérisé en ce que** les premiers et/ou deuxièmes outils de séparation (307, 308) sont des outils de séparation mécaniques, des jets de fluide ou des rayons énergétiques.

7. Procédé selon la revendication 4 ou 5, **caractérisé en ce que** les premiers et/ou deuxièmes outils de séparation (307, 308) sont des rayons laser, lesquels sont dirigés vers la pièce d'oeuvre par l'intermédiaire d'éléments de séparation de rayons ou de déviation de rayons fixés sur les éléments de support (303, 304).

8. Procédé selon la revendication 4 ou 5, **caractérisé en ce que** les premiers et/ou deuxièmes outils de séparation (307, 308) sont des rayons laser, lesquels sont guidés au moins partiellement le long des lignes de coupe (301, 302) par l'intermédiaire de dispositifs de balayage optiques fixés sur les éléments de support (303, 304).

9. Procédé selon la revendication 1 ou 2, **caractérisé en ce que** les premiers et deuxièmes outils de séparation (308, 307) sont des rayons énergétiques, lesquels sont guidés le long des premières et deuxièmes lignes de coupe (301, 302) par l'intermédiaire de dispositifs de balayage.

10. Procédé selon l'une des revendications 1 à 9, **caractérisé en ce que** l'on utilise plusieurs groupes de premiers et deuxièmes outils de séparation (307, 308) les uns derrière les autres dans le sens de la coupe.

11. Dispositif pour séparer une pièce d'oeuvre en plusieurs pièces partielles, lequel présente au moins :
- plusieurs premiers outils de séparation (308), lesquels sont disposés et formés pour la réalisation simultanée de plusieurs premières entailles dans une pièce d'oeuvre (300) le long de premières lignes de coupe (301),
- plusieurs deuxièmes outils de séparation (307), lesquels sont disposés et formés pour la réalisation simultanée de plusieurs deuxièmes entailles dans la pièce d'oeuvre (300) le long de deuxièmes lignes de coupe (302), les premières et deuxièmes lignes de coupe déterminant un plan dans lequel elles se coupent ou se rencontrent,
- une fixation de pièce d'oeuvre (400), et **caractérisé en ce que** le dispositif présente une commande (401), laquelle commande les outils de séparation (307, 308) pour la réalisation d'au moins une partie des premières entailles de manière simultanée avec la réalisation d'au moins une partie des deuxièmes entailles.

12. Dispositif selon la revendication 11, **caractérisé en ce que** les premiers outils de séparation (308) sont disposés le long d'un premier axe et les deuxièmes outils de séparation (307) le long d'un deuxième axe, les deux axes étant orientés parallèlement l'un par rapport à l'autre pendant la réalisation des entailles.

13. Dispositif selon la revendication 12, **caractérisé en ce que** les deux axes sont formés par des éléments de support (303, 304) sur lesquels sont fixés les outils de séparation (307, 308) ou des composants pour le guidage des outils de séparation (307, 308).

14. Dispositif selon la revendication 13, **caractérisé en ce que** les éléments de support (303, 304) sont montés de manière à pouvoir coulisser l'un par rapport à l'autre le long du premier ou deuxième axe.

15. Dispositif selon l'une des revendications 11 à 14, **caractérisé en ce que** les premiers et/ou deuxièmes outils de séparation (307, 308) sont des outils de séparation mécaniques ou des rayons énergétiques.

16. Dispositif selon l'une des revendications 11 à 15, **caractérisé en ce que** les premiers et/ou deuxièmes outils de séparation (307, 308) sont des rayons laser d'un ou plusieurs lasers, lesquels peuvent être guidés par l'intermédiaire de dispositifs de balayage optique au moins partiellement le long des lignes de coupe (301, 302).
